(19) Europäisches Patentamt
European Patent Office
Office européen des brevets

(11) **EP 2 534 535 B1**

(12) **EUROPÄISCHE PATENTSCHRIFT**

(45) Veröffentlichungstag und Bekanntmachung des Hinweises auf die Patenterteilung:
**02.03.2016 Patentblatt 2016/09**

(21) Anmeldenummer: **10799054.1**

(22) Anmeldetag: **28.12.2010**

(51) Int Cl.:
**G02F 1/13357** *(2006.01)*   **G02B 27/09** *(2006.01)*

(86) Internationale Anmeldenummer:
**PCT/EP2010/070820**

(87) Internationale Veröffentlichungsnummer:
**WO 2011/098191 (18.08.2011 Gazette 2011/33)**

(54) **OPTOELEKTRONISCHES HALBLEITERBAUELEMENT, BELEUCHTUNGSEINRICHTUNG UND LINSE**

OPTOELECTRONIC SEMICONDUCTOR COMPONENT, ILLUMINATION DEVICE AND LENS

COMPOSANT SEMI-CONDUCTEUR OPTOÉLECTRONIQUE, DISPOSITIF D'ILLUMINATION ET LENTILLE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **12.02.2010 DE 102010007751**

(43) Veröffentlichungstag der Anmeldung:
**19.12.2012 Patentblatt 2012/51**

(73) Patentinhaber: **OSRAM Opto Semiconductors GmbH**
**93055 Regensburg (DE)**

(72) Erfinder: **BRICK, Peter**
**93051 Regensburg (DE)**

(74) Vertreter: **Epping - Hermann - Fischer Patentanwaltsgesellschaft mbH**
**Schloßschmidstraße 5**
**80639 München (DE)**

(56) Entgegenhaltungen:
**WO-A1-2009/015605     CN-Y- 201 330 994**
**US-A1- 2009 032 827     US-B1- 6 273 596**

**Beschreibung**

Es wird eine Linse angegeben. Darüber hinaus wird ein optoelektronisches Halbleiterbauelement mit einer solchen Linse und eine Beleuchtungseinrichtung mit solchen optoelektronischen Halbleiterbauteilen angegeben.

In der Druckschrift DE 10 2006 050 880 A1 sind ein optoelektronisches Bauteil und eine Beleuchtungseinrichtung angegeben.

Die Druckschrift CN 201330994 (Y) betrifft eine Leuchtdiode mit einer speziell geformten Linse.

Eine Leuchtdioden-Tunnellampe findet sich in der Druckschrift WO 2009/015605 A1.

Die Beschreibung einer Linse für eine Leuchtdiode ist in der Druckschrift US 2009/0032827 A1 angegeben.

Es betrifft die Druckschrift US 6,273,596 B1 eine Linse für eine Beleuchtungseinrichtung.

Eine zu lösende Aufgabe besteht darin, eine Linse anzugeben, die eine davon beabstandete Fläche gleichmäßig ausleuchtet. Weiterhin besteht eine zu lösende Aufgabe darin, ein Halbleiterbauteil mit einer solchen Linse und eine Beleuchtungseinrichtung mit solchen Halbleiterbauteilen anzugeben.

Diese Aufgaben werden gelöst durch eine Linse, ein Halbleiterbauteil und eine Beleuchtungseinrichtung mit den Merkmalen der unabhängigen Patentansprüche.

Gemäß zumindest einer Ausführungsform des optoelektronischen Halbleiterbauteils umfasst dieses einen Träger mit einer Trägeroberseite. Der Träger umfasst oder besteht bevorzugt aus einer Keramik, einem Glas, einer Metallkernplatine oder einer Leiterplatte. Der Träger kann Einrichtungen zu einer elektrischen Kontaktierung aufweisen, zum Beispiel Durchkontaktierungen und elektrisch leitfähige Beschichtungen in Teilbereichen an der Trägeroberseite und/oder an einer der Trägeroberseite gegenüberliegenden Trägerunterseite.

Gemäß zumindest einer Ausführungsform des Halbleiterbauteils umfasst dieses mindestens einen optoelektronischen Halbleiterchip, der an der Trägeroberseite angebracht ist. Bevorzugt handelt es sich bei dem Halbleiterchip um eine Leuchtdiode. Insbesondere basiert der Halbleiterchip auf mindestens einem anorganischen Halbleitermaterial. Optional umfasst der Halbleiterchip ein Konversionselement, wobei das Konversionselement dazu eingerichtet ist, eine in einer aktiven Halbleiterschicht des Halbleiterchips erzeugte elektromagnetische Strahlung wenigstens teilweise in eine Strahlung einer anderen Wellenlänge umzuwandeln.

Gemäß zumindest einer Ausführungsform des Halbleiterbauteils weist der Halbleiterchip eine insbesondere der Trägeroberseite abgewandte Strahlungsdurchtrittsseite auf. Die Strahlungsdurchtrittsseite ist eine Hauptseite des Halbleiterchips und insbesondere parallel zu der Trägeroberseite orientiert. Durch die Strahlungsdurchtrittsseite ist ferner eine Ebene definiert. Insbesondere ist die Strahlungsdurchtrittsseite ein Teil der Ebene, wobei Haupterstreckungsrichtungen der Strahlungsdurchtrittsseite in der Ebene liegen. Beispielsweise ist die Ebene senkrecht zu einer Wachstumsrichtung einer Halbleiterschichtenfolge des Halbleiterchips orientiert, wobei die Ebene die Strahlungsdurchtrittsseite möglichst so schneidet, dass die Ebene eine Ausgleichsebene der Strahlungsdurchtrittsseite ist, die sich etwa durch Mittelung über zum Beispiel Strukturen einer Aufrauung hinweg ergibt.

Gemäß zumindest einer Ausführungsform des Halbleiterbauteils weist dieses zumindest eine Linse auf. Die Linse umfasst eine Strahlungsaustrittsfläche, die eine dem Träger abgewandte Begrenzungsfläche der Linse ist. Bevorzugt ist die Strahlungsaustrittsfläche eine zusammenhängende, glatte Fläche, über die die vom Halbleiterchip erzeugte Strahlung vollständig oder überwiegend das Halbleiterbauteil verlässt. Es weist die Linse bevorzugt genau eine Strahlungsaustrittsfläche auf. Glatt kann heißen, dass die Strahlungsaustrittsfläche frei von Ecken und Kanten ist und/oder differenzierbar ist. Die Linse ist wenigstens für einen Teil der im Halbleiterchip erzeugten Strahlung durchlässig, bevorzugt klarsichtig. Für jeden Punkt der Strahlungsaustrittsfläche ist eine Höhe angebbar. Die Höhe ist ein Abstand des entsprechenden Punkts der Strahlungsaustrittsfläche zu der durch die Strahlungsdurchtrittsseite des Halbleiterchips definierten Ebene, gemessen in einer Richtung senkrecht zu der Ebene.

Gemäß zumindest einer Ausführungsform des Halbleiterbauteils weist die Linse ein Minimum auf. Das Minimum befindet sich insbesondere in einem Zentralbereich der Linse. Der Zentralbereich ist bevorzugt konkav gekrümmt und von einem Randbereich, der bevorzugt konvex gekrümmt ist, umgeben. Minimum bedeutet, dass zumindest in einer lokalen Umgebung des Minimums die Höhe der Strahlungsaustrittsfläche, bezogen auf die Ebene, am kleinsten ist.

Gemäß zumindest einer Ausführungsform des Halbleiterbauteils weist die Linse eine optische Achse auf. Zum Beispiel ist die optische Achse senkrecht zu der Ebene, die durch die Strahlungsdurchtrittsseite des Halbleiterchips definiert ist, orientiert und stellt eine Symmetrieachse oder eine Gerade dar, die in wenigstens einer Symmetrieebene der Linse angeordnet ist. Bevorzugt durchstößt die optische Achse die Strahlungsaustrittsfläche der Linse in dem Zentralbereich, insbesondere in dem Minimum.

Gemäß zumindest einer Ausführungsform des Halbleiterbauteils weist die Linse mindestens zwei lokale Maxima auf, die bevorzugt in dem konvex gekrümmten Randbereich liegen. Mit anderen Worten weisen die Maxima dann einen größeren Abstand zur optischen Achse auf als das Minimum. Ein Maximum ist ein solcher Bereich der Strahlungsaustrittsfläche, der, im Vergleich zu einer Umgebung an der Strahlungsaustrittsfläche, eine größere Höhe, bezogen auf die durch die Strahlungsdurchtrittsseite definierte Ebene, aufweist. Bevorzugt befinden sich die Maxima, in Draufsicht gesehen, jeweils in Eckbereichen der Linse.

Gemäß zumindest einer Ausführungsform des Halbleiterbauteils weist die Linse mindestens zwei Verbindungswälle auf. Die Verbindungswälle sind erhabene, bergrückenartige Strukturen der Linse, die von einem der Maxima zu einem anderen der Maxima der Strahlungsaustrittsfläche reichen. Eine Kammlinie der Verbindungswälle liegt, bezogen auf die durch die Strahlungsdurchtrittsseite definierte Ebene, höher als das Minimum der Strahlungsaustrittsfläche und tiefer als die an den Verbindungswall angrenzenden Maxima. Im Bereich der Kammlinie oder eines höchsten Punktes der Verbindungswälle weisen diese insbesondere, in einem Querschnitt gesehen, eine parabelartige Form auf. Das Minimum wird vollständig von den Verbindungswällen und/oder den Maxima umrandet oder wird umrahmt. Weiterhin ist es möglich, dass die Kammlinie, insbesondere in Draufsicht gesehen, eine gerade Linie ist.

Gemäß zumindest einer Ausführungsform des Halbleiterbauteils weist jeder Verbindungswall einen Sattelpunkt auf. Der Sattelpunkt liegt höher als das Minimum und tiefer als die an den Verbindungswall grenzenden Maxima. Der Sattelpunkt kann ein tiefster Punkt der Kammlinie des Verbindungswalls sein und gleichzeitig ein höchster Punkt der Strahlungsaustrittsfläche entlang einer radialen Richtung von der optischen Achse weg.

Gemäß zumindest einer Ausführungsform des Halbleiterbauteils ist die Strahlungsaustrittsfläche der Linse durch eine zweidimensionale, differenzierbare Funktion beschreibbar und/oder approximierbar. Zweidimensional bedeutet insbesondere, dass die Funktion von zwei Variablen abhängt, durch die beispielsweise die Strahlungsdurchtrittsseite des Halbleiterchips oder eine Ebene parallel zu der Strahlungsdurchtrittsseite aufspannbar ist, und dass die Funktion einen Funktionswert für eine Koordinate in eine Richtung senkrecht zu der Strahlungsdurchtrittsseite oder zu dieser Ebene liefert. Das heißt, insbesondere ein mittlerer Verlauf der Strahlungsaustrittsfläche der Linse ist durch diese Funktion wiedergebbar. Beispielsweise entspricht die Funktion einer Formgebung einer Gussform, mit der die Linse hergestellt ist. Mit anderen Worten kann die differenzierbare Funktion eine Sollform der Strahlungsaustrittsfläche sein. Von dieser Sollform können kleinere Abweichungen auftreten, etwa herstellungsbedingt oder durch Unregelmäßigkeiten in einem Material der Linse.

Ist die Strahlungsaustrittsfläche durch eine solche differenzierbare Funktion wiedergebbar, so liegt den Begriffen Minimum, Maximum und Sattelpunkt bezüglich dieser Funktion, die die Strahlungsaustrittsfläche wiedergibt, bevorzugt eine Bedeutung in ihrem mathematischen Sinn inne. Insbesondere ist dann in dem Minimum und in den Maxima die erste Ableitung der Funktion gleich Null und an dem Minimum sowie an den Maxima erfolgt ein Vorzeichenwechsel der zweiten Ableitung.

In mindestens einer Ausführungsform des optoelektronischen Halbleiterbauteils ist dieses für eine Beleuchtungseinrichtung vorgesehen und weist einen Träger sowie wenigstens einen optoelektronischen Halbleiterchip auf. Der Halbleiterchip ist an dem Träger angebracht und weist eine dem Träger abgewandte Strahlungsdurchtrittsseite auf, durch die eine Ebene definiert ist. Außerdem beinhaltet das Halbleiterbauteil eine Linse mit einer Strahlungsaustrittsfläche. Jeweils bezogen auf eine Höhe über der Ebene weist die Linse ein Minimum, insbesondere in einem Zentralbereich der Strahlungsaustrittsfläche, sowie mindestens zwei lokale Maxima und mindestens zwei Verbindungswälle auf. Die Verbindungswälle reichen jeweils von einem der Maxima zu einem anderen der Maxima und umfassen je einen Sattelpunkt, der höher als das Minimum und tiefer als die an den Verbindungswall angrenzenden Maxima liegt. Bevorzugt ist die Linse, beispielsweise über ein Spritzgießen oder ein Spritzpressen, an den Halbleiterchip und an den Träger angeformt.

Mit anderen Worten beinhaltet das Halbleiterbauteil bevorzugt eine Linse, bei der ein um einen Zentralbereich umlaufender Rand keine konstante Höhe aufweist. Hierdurch wird in eine laterale Richtung weg von der optischen Achse, wobei die laterale Richtung definiert ist durch die optische Achse und durch eines der Maxima, ein größerer Strahlungsanteil emittiert als im Falle einer Linse, die einen Rand mit konstanter Höhe aufweist. Sind die Halbleiterbauteile beispielsweise in einem quadratischen Raster auf einer Anschlussplatte einer Beleuchtungseinrichtung angeordnet, sodass in einer diagonalen Richtung ein Abstand zwischen benachbarten Halbleiterbauteilen vergrößert ist, so kann durch eine solche Linse mehr Strahlung entlang der diagonalen Richtung emittiert werden und hierdurch eine gleichmäßigere Ausleuchtung einer zu beleuchtenden Fläche erzielt werden.

Gemäß zumindest einer Ausführungsform des Halbleiterbauteils beträgt eine laterale Abmessung der Linse, gemessen in der durch die Strahlungsdurchtrittsseite definierten Ebene, höchstens ein Zehnfaches einer lateralen Ausdehnung des Halbleiterchips entlang derselben Richtung. Insbesondere beträgt die laterale Abmessung der Linse höchstens ein Fünffaches oder höchstens ein Dreifaches der lateralen Ausdehnung des Halbleiterchips. Mit anderen Worten ist die laterale Abmessung der Linse vergleichbar mit der lateralen Ausdehnung des Halbleiterchips. Die Linse ist also vergleichsweise klein gestaltet.

Gemäß zumindest einer Ausführungsform des Halbleiterbauteils ist die laterale Abmessung der Linse, gemessen in der Ebene, mindestens 1,5-fach oder mindestens 2-fach so groß wie die laterale Ausdehnung des Halbleiterchips, gemessen in derselben Richtung. Bevorzugt liegt die laterale Abmessung der Linse zwischen einschließlich dem 2,5- Fachen und dem 3,5-Fachen der lateralen Ausdehnung des Halbleiterchips.

Gemäß zumindest einer Ausführungsform des Halbleiterbauteils beträgt ein Abstand zwischen zwei benachbarten Maxima zwischen einschließlich dem 0,4-Fachen und dem 0,9-Fachen der maximalen lateralen Abmessung der Linse. Die Abmessung der Linse ist hierbei in der Ebene, die durch die Strahlungsdurchtrittsseite definiert ist, und entlang derselben Richtung wie der Abstand zwischen den zwei Maxima zu bestimmen. Mit anderen Worten wird der Abstand zwischen den zwei Maxima in Draufsicht auf das Halbleiterbauteil bestimmt, ebenso wie die laterale Abmessung der Linse. Der Abstand zwischen den Maxima liegt insbesondere zwischen einschließlich dem 0,5-Fachen und dem 0,85-Fachen der lateralen Abmessung der Linse.

Gemäß zumindest einer Ausführungsform des Halbleiterbauteils beträgt eine Höhe $H_S$ des Sattelpunkts mindestens ein 1,05-Faches, bevorzugt mindestens ein 1,2-Faches einer Höhe $H_{min}$ des Minimums. Alternativ oder zusätzlich beträgt die Höhe $H_S$ des Sattelpunkts höchstens ein 2,0-Faches oder höchstens ein 1,5-Faches der Höhe $H_{min}$ des Minimums.

Gemäß zumindest einer Ausführungsform des Halbleiterbauteils beträgt eine Höhe $H_{max}$ der Maxima, bezogen auf die Ebene, jeweils mindestens ein 1,05-Faches oder mindestens ein 1,25-Faches der Höhe $H_{min}$ des Minimums. Alternativ oder zusätzlich beträgt die Höhe $H_{max}$ der Maxima jeweils höchstens ein 2,25-Faches oder ein 1,75-Faches der Höhe $H_{min}$ des Minimums.

Gemäß zumindest einer Ausführungsform des Halbleiterbauteils beträgt die Höhe $H_{min}$ des Minimums, bezogen auf die Ebene, höchstens ein 4,0-Faches oder höchstens ein 1,0-Faches einer Kantenlänge des Halbleiterchips. Alternativ oder zusätzlich beträgt die Höhe $H_{min}$ des Minimums mindestens ein 0,6-Faches oder mindestens ein 0,8-Faches der Kantenlänge des Halbleiterchips. Ist der Halbleiterchip quadratisch geformt, so ist die Kantenlänge eine Seitenlänge oder eine mittlere Seitenlänge des Halbleiterchips, in Draufsicht gesehen.

Gemäß zumindest einer Ausführungsform des Halbleiterbauteils ist ein Betrag einer mittleren Krümmung der Strahlungsaustrittsfläche der Linse in dem Zentralbereich kleiner als ein Betrag der Krümmung in den Maxima und in den Sattelpunkten. Mit anderen Worten ist die Strahlungsaustrittsfläche im Bereich der Maxima und der Sattelpunkte, im Vergleich zu dem Zentralbereich, stärker gekrümmt.

Gemäß zumindest einer Ausführungsform des Halbleiterbauteils weist der Betrag der Krümmung der Strahlungsaustrittsfläche einen Maximalwert an einer solchen Stelle der Strahlungsaustrittsfläche der Linse auf, die weiter von der optischen Achse beabstandet ist als der Sattelpunkt oder das Maximum. Die Linse ist dabei in einem Querschnitt zu sehen, wobei der Querschnitt parallel zur und durch die optische Achse sowie durch den entsprechenden Sattelpunkt oder das entsprechende Maximum verläuft. Mit anderen Worten liegt eine maximale Krümmung dann nicht in dem Maximum oder in dem Sattelpunkt vor, sondern an einer Stelle der Strahlungsaustrittsfläche, die weiter von der optischen Achse entfernt liegt. Bevorzugt ist der Betrag der Krümmung in lateraler Richtung in einem Bereich maximal, der außerhalb eines von den Maxima und den Kammlinien der Verbindungswälle umgebenen Bereichs der Strahlungsaustrittsfläche liegt.

Gemäß zumindest einer Ausführungsform des Halbleiterbauteils liegt ein Winkel θ2 zwischen der optischen Achse und den Sattelpunkten, bezogen auf einen Durchstoßpunkt der optischen Achse durch die Strahlungsdurchtrittsseite des Halbleiterchips, zwischen einschließlich 30° und 50°, insbesondere zwischen einschließlich 35° und 45°. Alternativ oder zusätzlich liegt ein Winkel θ1 zwischen der optischen Achse und den Maxima, bezogen auf den Durchstoßpunkt, zwischen einschließlich 35° und 60°, insbesondere zwischen einschließlich 40° und 55°. Bevorzugt gilt ferner, dass der Winkel θ2 jeweils kleiner ist als der Winkel θ1.

Darüber hinaus wird eine Beleuchtungseinrichtung und eine Linse angegeben. Die Beleuchtungseinrichtung beinhaltet bevorzugt eine Mehrzahl von optoelektronischen Halbleiterbauteilen, wie in Verbindung mit einem oder mehreren der vorangegangen Ausführungsformen angegeben. Die Linse ist zum Beispiel in einer Ausführungsform der Halbleiterbauteile, wie vorangehend angegeben, eingesetzt. Merkmale für das optoelektronische Halbleiterbauteil sind daher auch für die Beleuchtungseinrichtung sowie für die Linse offenbart und umgekehrt.

Gemäß zumindest einer Ausführungsform der Beleuchtungseinrichtung umfasst diese eine Mehrzahl von optoelektronischen Halbleiterbauteilen sowie eine Anschlussplatte. Bei der Anschlussplatte kann es sich um eine Platine und/oder um eine Leiterplatte handeln. Mindestens ein Teil der Halbleiterbauteile ist an Gitterpunkten eines regelmäßigen Gitters auf der Anschlussplatte angeordnet.

In mindestens einer Ausführungsform der Linse ist diese für ein optoelektronisches Halbleiterbauteil für eine Beleuchtungseinrichtung vorgesehen und weist eine Strahlungsaustrittsfläche und eine optische Achse auf. Die Strahlungsaustrittsfläche weist ein Minimum auf, das insbesondere von der optischen Achse durchstoßen ist und insbesondere in einem Zentralbereich, der Strahlungsaustrittsfläche liegt. Weiterhin weist die Strahlungsaustrittsfläche mindestens zwei Maxima sowie mindestens einen, besonders bevorzugt mindestens zwei Verbindungswälle auf. Über die Verbindungswälle ist jeweils eines der Maxima mit einem anderen der Maxima wallartig verbunden. Die Verbindungswälle, zusammen mit den Maxima, umringen das Minimum in einer lateralen Richtung vollständig. Jeder Verbindungswall weist einen Sattelpunkt auf, der höher als das Minimum und tiefer als die an den Verbindungswall angrenzenden Maxima liegt.

Nachfolgend wird eine hier beschriebene Linse, ein hier beschriebenes optoelektronisches Halbleiterbauteil sowie eine hier beschriebene Beleuchtungseinrichtung unter Bezugnahme auf die Zeichnung anhand von Ausführungsbeispielen näher erläutert. Gleiche Bezugszeichen geben dabei gleiche Elemente in den einzelnen Figuren an. Es sind dabei jedoch keine maßstäblichen Bezüge dargestellt, vielmehr können einzelne Elemente zum besseren Verständnis übertrieben groß dargestellt sein.

Es zeigen:

Figuren 1 bis 3, 8 und 12    schematische Darstellungen von Ausführungsbeispielen von hier beschriebenen optoelektronischen Halbleiterbauteilen,

Figuren 4    bis 6 und 9 schematische Darstellungen von Ausführungsbeispielen von hier beschriebenen Linsen,

Figur 7    eine schematische Darstellung einer Abwandlung einer Linse,

Figuren 10 und 11    schematische Darstellungen von Ausführungsbeispielen von hier beschriebenen Beleuchtungseinrichtungen, und

Figur 13    eine schematische Darstellung einer Abstrahlcharakteristik eines hier beschriebenen Halbleiterbauteils in einem optischen Fernfeld.

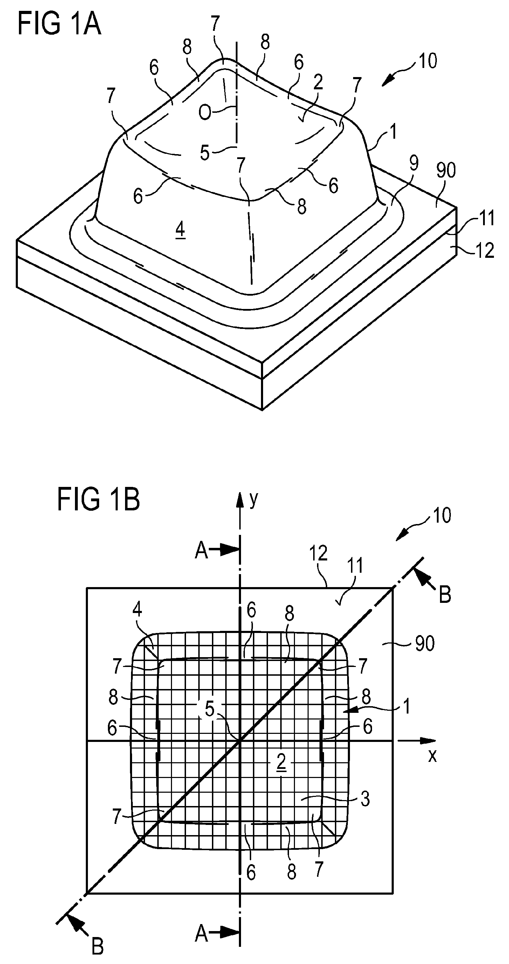

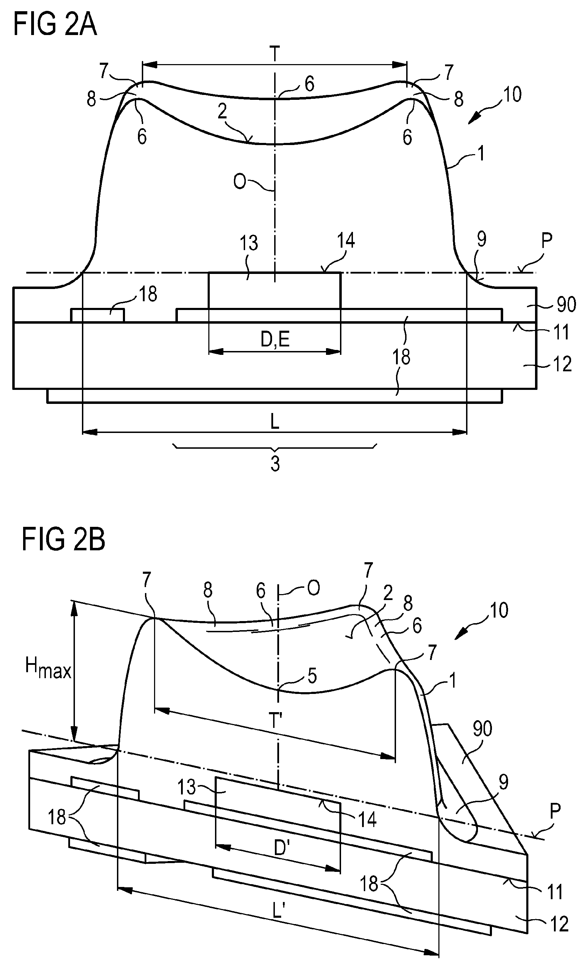

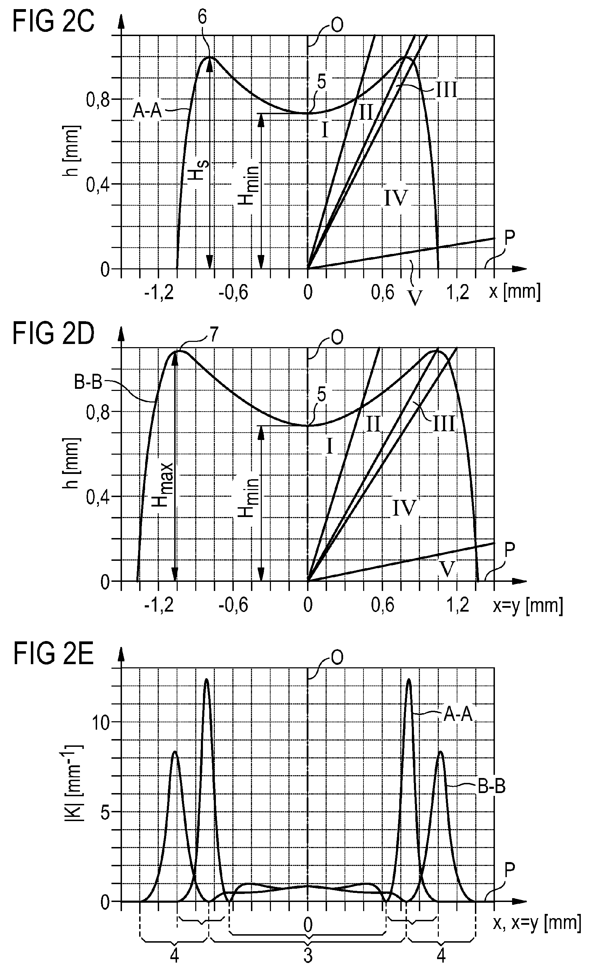

In Figur 1A ist eine schematische, perspektivische Darstellung und in Figur 1B eine Draufsicht auf ein Halbleiterbauteil 10 gezeigt. Weiterhin ist in Figur 2A eine Schnittdarstellung entlang der Linie AA aus Figur 1B und in Figur 2B eine Schnittdarstellung entlang der Linie BB in Figur 1B illustriert. In den Figuren 2C, 2D und 2E sind Höhen h sowie ein Betrag eines Krümmungsradiuses |K| zu einer Linse 1 des Halbleiterbauteils 10 gemäß Figur 1 gezeigt.

Das Halbleiterbauteil 10 weist einen zum Beispiel keramischen Träger 12 mit einer Trägeroberseite 11 auf. Auf der Trägeroberseite 11 ist ein optoelektronischer Halbleiterchip 13 mit einer Strahlungsdurchtrittsseite 14 angebracht. Bei dem Halbleiterchip 13 handelt es sich bevorzugt um eine Leuchtdiode, die im Betrieb ultraviolette und/oder sichtbare Strahlung emittiert. Der Träger 12 umfasst ferner elektrische Anschlüsse 18, die an der Trägeroberseite 11 sowie an einer der Trägeroberseite 11 gegenüberliegenden Trägerunterseite angebracht und zu einer elektrischen Kontaktierung des Halbleiterchips 13 eingerichtet sind. Durch die dem Träger 12 abgewandte Strahlungsdurchtrittsseite 14 des Halbleiterchips 13 ist eine Ebene P definiert, die parallel zur Trägeroberseite 11 orientiert ist und wobei die Strahlungsdurchtrittsseite 14 ein Teil der Ebene P ist.

Die Linse 1 ist, beispielsweise über ein Spritzgießen oder ein Spritzpressen, auf dem Träger 12 erzeugt und an den Träger 12 sowie an den Halbleiterchip 13 formschlüssig angeformt. Mit anderen Worten ist kein Luftspalt zwischen dem Halbleiterchip 13 und der Linse 1 ausgebildet. Da die Linse 1 an den Träger 12 angeformt ist, sind keine Haltevorrichtungen an der Linse 1 ausgebildet. Eine mechanische Fixierung der Linse an dem Träger 12 erfolgt also über Adhäsionskräfte eines Materials der Linse 1 mit insbesondere der Trägeroberseite 11 und den elektrischen Anschlüssen 18.

Zur Verbesserung einer Haftung der Linse 1 an der Trägeroberseite 11 ist der Linse 1 optional ein Sockel 90 angegliedert, der sich über die gesamte Trägeroberseite 11 erstreckt. Eine dem Träger 12 abgewandte Oberseite des Sockels 90 verläuft bevorzugt parallel zur Trägeroberseite 11. In einem Übergangsbereich zwischen der Linse 1 und dem Sockel 90 ist eine Randverrundung 9 ausgebildet, über die ein sanfter Übergang zwischen der Linse 1 und dem Sockel 90 gewährleistet ist. Durch die Randverrundung 9 können insbesondere Materialspannungen sowie eine Gefahr einer Rissbildung in oder an der Linse 1 reduziert sein. Eine Höhe der Randverrundung 9 beträgt zum Beispiel höchstens 25 % oder höchstens 15 % der Höhe der Maxima 7, bezogen auf die Oberseite des Sockels 90 oder bezogen auf die Ebene P.

Die Linse 1 weist eine Strahlungsaustrittsfläche 2 auf, durch die die im Halbleiterchip 13 im Betrieb erzeugte Strahlung das Halbleiterbauteil 10 verlässt. Eine optische Achse O der Linse 1 verläuft senkrecht zu der Ebene P, bevorzugt auch zentral durch den Halbleiterchip 13. In einem Zentralbereich 3 der Linse 1 befindet sich ein Minimum 5. Im Bereich des Minimums 5 ist die Strahlungsaustrittsfläche 2 von der optischen Achse O durchstoßen. Weiterhin umfasst die Linse 1 vier Maxima 7 sowie vier Verbindungswälle 8, die das Minimum 5 in dem Zentralbereich 3 vollständig rahmenartig umgeben, vergleiche insbesondere Figur 1B. Die Maxima 7 liegen jeweils auf einer gleichen Höhe $H_{max}$, bezogen auf die Ebene P. Die Verbindungswälle 8, die sich zwischen jeweils zwei der Maxima 7 erstrecken, umfassen je einen Sattelpunkt 6, der höher als das Minimum 5 und tiefer als die Maxima 7 liegt.

Durch eine x-Achse und durch eine y-Achse, vergleiche Figur 1B, ist die Linse 1 in Draufsicht gesehen in vier Quadranten aufgeteilt. Die vier Quadranten der Linse 1 sind gleichartig geformt. In Draufsicht gesehen weist die Linse 1 eine quadratische Grundform mit abgerundeten Ecken auf.

Der Halbleiterchip 1 weist beispielsweise eine Kantenlänge E von zirka 750 $\mu$m auf, vergleiche Figur 2A. Eine laterale Abmessung L der Linse, gemessen in der Ebene P, liegt gemäß Figur 2A bei zirka 2100 $\mu$m. Ein Abstand T zwischen den Maxima 7 liegt bei zirka 1500 $\mu$m, ein Abstand zwischen einander gegenüberliegenden Sattelpunkten 6 bei zirka 1600 $\mu$m. Da die Linse 1 einen quadratischen Grundriss aufweist, sind der Abstand T', die laterale Abmessung L' sowie die laterale Ausdehnung D' des Halbleiterchips 13 gemäß der Schnittdarstellung in Figur 2B jeweils um einen

Faktor $\sqrt{2}$ größer als gemäß Figur 2A. Eine Höhe $H_{min}$ des Minimums 5 beträgt zirka 730 $\mu$m, eine Höhe $H_S$ der Sattelpunkte 6 zirka 990 $\mu$m und die Höhe $H_{max}$ der Maxima 7 liegt bei ungefähr 1080 $\mu$m. Eine gesamte laterale Ausdehnung des Trägers 12, vergleiche Figur 2A, liegt bei ungefähr 3,0 mm.

In Figur 2C ist ein Verlauf der Strahlungsaustrittsfläche 2 der Linse 1 entlang der x-Achse dargestellt, aufgetragen in mm gegenüber der Höhe h über der Ebene P. In Figur 2D ist eine entsprechende Darstellung entlang der Linie BB in Figur 1B gezeigt. In Figur 2E ist schließlich ein Betrag der Krümmung |K| der Strahlungsaustrittsfläche 2 entlang der Linien AA und BB in Figur 1B illustriert.

Die Höhe h der Strahlungsaustrittsfläche 2 der Linse 1 lässt sich, bezogen auf die Ebene P, durch ein Polynom achten Grades angeben. Insbesondere ist das Polynom eine zweidimensionale Funktion und hat die Form

$$h(x,y) = a_0 + a_1 x + a_2 y + a_3 (x^2+y^2) + a_4 (x^4+y^4) + a_5 (x^2 y^2) + a_6 (x^6+y^6) + a_7 (x^4 y^2 + x^2 y^4) + a_8 (x^8+y^8)$$

Insbesondere mit einer Toleranz von höchstens dem 0,1-Fachen, bevorzugt von höchstens dem 0,05-Fachen oder von höchstens dem 0,02-Fachen liegt ein jeweiliger realer Wert der Höhe h(x,y) an dem Wert, der sich aus der oben genannten Formel ergibt. Alternativ oder zusätzlich beträgt die Toleranz für die Höhe h(x,y) höchstens 0,3 mm oder höchstens 0,1 mm.

Mindestens die Koeffizienten $a_0$, $a_3$, $a_5$ und $a_7$ sind $\neq 0$. Beim Ausführungsbeispiel gemäß Figur 1 sind alle Koeffizienten, außer den Koeffizienten $a_1$ und $a_2$, $\neq 0$. Bevorzugt sind die Koeffizienten $a_0$, $a_3$, $a_6 > 0$ und/oder die Koeffizienten $a_4$, $a_5$, $a_7$ und $a_8 < 0$. Bevorzugt gilt weiterhin, dass der Betrag des Koeffizienten $a_5$ größer ist als der Betrag des Koeffizienten $a_4$, der wiederum bevorzugt kleiner ist als der Betrag des Koeffizienten $a_7$. Weiterhin können, vom Betrag her, die Koeffizienten $a_6$ und $a_8$ größer sein als die restlichen Koeffizienten, wobei insbesondere der Betrag des Koeffizient $a_8$ maximal ist. Speziell mit der angegebenen Toleranz für die Höhe h(x,y) gilt für die Linse gemäß Figur 1 der folgende Zusammenhang:

$$h(x,y) = 0,73 + 0,44(x^2+y^2) - 0,22(x^4+y^4) - 0,31(x^2 y^2) + 1,64(x^6+y^6) - 0,18(x^4 y^2 + x^2 y^4) - 2,12(x^8+y^8)$$

In dem Zentralbereich 3 ist die die Strahlungsaustrittsfläche 2 der Linse 1 konkav und in dem Randbereich 4 konvex gekrümmt. Eine Grenze des Zentralbereichs 3 zu dem Randbereich 4 verläuft somit insbesondere entlang einer Linie, an der sich ein Vorzeichen der Krümmung der Strahlungsaustrittsfläche 2 ändert. Die Sattelpunkte 6 sowie die Maxima 7 liegen jeweils in dem Randbereich 4. Eine Stelle mit einem maximalen Betrag der Krümmung der Strahlungsaustrittsfläche 2 liegt weiter von der optischen Achse O entfernt als die Maxima 7 und die Sattelpunkte 6, vergleiche Figur 2E. Die optional vorhandene Randverrundung 9 und der Sockel 90 sind in den Figuren 2C, 2D und 2E sowie in den angegebenen Formeln jeweils nicht berücksichtigt.

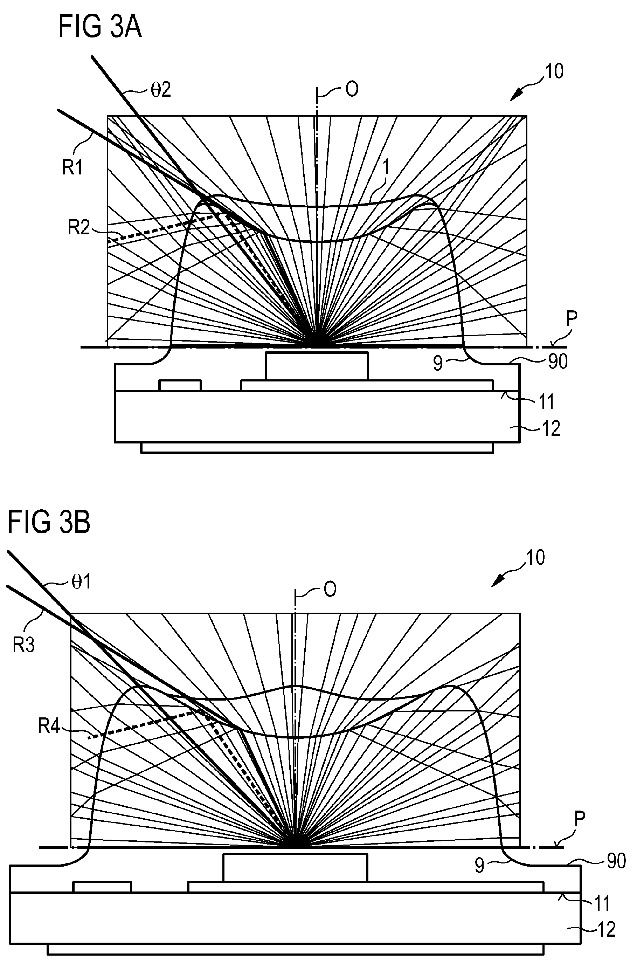

Eine Abstrahlcharakteristik der Linse 1 ist entlang der Linie AA aus Figur 1B in Figur 3A und entlang der Linie BB gemäß Figur 1B in Figur 3B illustriert. Die im Folgenden angegebenen Winkel und Winkelbereiche sind bezogen auf die optische Achse O und auf einen Durchstoßpunkt der optischen Achse O durch die Strahlungsdurchtrittsseite 14 des Halbleiterchips 13, siehe auch die Figuren 2C und 2D.

In einem ersten Winkelbereich I von zirka 0° bis zirka 25° erfolgt jeweils eine Brechung von im Durchstoßpunkt der Strahlungsdurchtrittsseite 14 emittierter Strahlung bei Durchgang durch die Strahlungsaustrittsfläche 2 der Linse 1 von der optischen Achse O weg, siehe die Strahlen R1 und R3 in Figur 3. In einem optional gegebenen Winkelbereich II von zirka 26° bis zirka 40° erfolgt eine interne Totalreflexion an der Strahlungsaustrittsfläche 2, sodass eine Strahlung weg von der optischen Achse O gelenkt wird, vergleiche die Strahlen R2 und R4. In einem dritten Bereich III, der vergleichsweise klein ist, erfolgt eine Brechung von Strahlung von der optischen Achse O weg. In einem vierten Bereich IV erfolgt wiederum eine Brechung zu der optischen Achse O hin, in einem Winkelbereich von zirka 45° bis zirka 84°. In einem fünften Bereich V zwischen ungefähr 84° und 90° erfolgt erneut eine Brechung zu der optischen Achse O hin.

Gemäß Figur 3A liegt ein Grenzwinkel $\theta$2, bis zu dem hin an der Strahlungsaustrittsfläche 2 eine Brechung weg von der optischen Achse O erfolgt, bei zirka 41,2°, gemäß Figur 3B bei zirka 47,5°. Eine Winkelposition der Sattelpunkte 6 liegt ferner bei ungefähr bei zirka 38,5°, siehe Figur 3A, und eine Winkelposition der Maxima 7 bei zirka 43,6°, siehe Figur 3B.

Ein Verlauf der Strahlen bezieht sich in den Figuren 2 und 3 jeweils auf einen Brechungsindex eines Materials der Linse 1 von zirka 1,4. Bei Materialien mit davon abweichendem Brechungsindex ist eine Form der Strahlungsaustrittsfläche 2 anzupassen, um einen entsprechenden Verlauf der Strahlen zu erzielen.

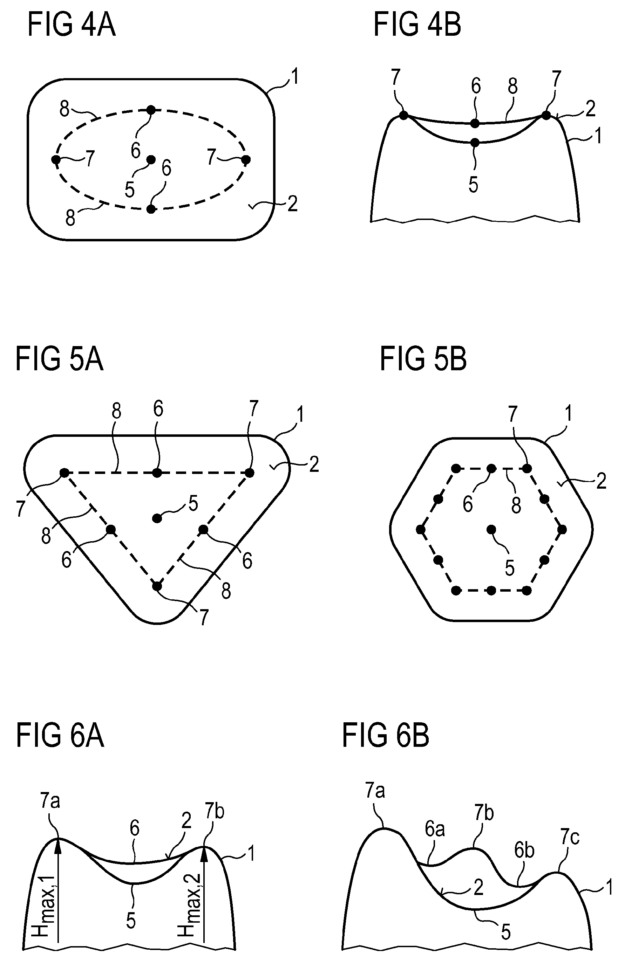

In den Figuren 4 bis 6 sind weitere Ausführungsbeispiele der Linse 1 dargestellt, siehe die Draufsichten in den Figuren 4A, 5A, 5B sowie die Schnittdarstellungen in den Figuren 4B, 6A, 6B. Gemäß Figur 4 weist die Linse 1 zwei Maxima 7 sowie zwei Verbindungswälle 8 und zwei Sattelpunkte 6 auf. Die Verbindungswälle 8 sind gekrümmt geformt, siehe Figur 4A, und schließen das Minimum 5 ringsum vollständig ein, zusammen mit den Maxima 7. Kammlinien der Verbindungswälle 8 sind in den Figuren als Strich-Linien gezeichnet. In Draufsicht gesehen ist eine Grundform der Linse 1 rechteckig, mit abgerundeten Ecken, wobei sich die Maxima 7 an den Ecken befinden.

Die Linse 1 gemäß Figur 5A weist in Draufsicht eine dreieckige Grundform auf und umfasst drei Maxima 7 sowie drei Sattelpunkte 6. Die Linse 1 gemäß Figur 5B ist in Draufsicht sechseckartig geformt und weist, wie auch die Linse gemäß 5A, abgerundete Ecken auf. Die Verbindungswälle 8 verbinden die zugehörigen Maxima, in Draufsicht gesehen, in einer geraden Linie. Die Linse 1 kann also eine gleiche Anzahl von Maxima, Sattelpunkten und Verbindungswällen aufweisen.

Die Ausführungsbeispiele der Linse 1 gemäß den Figuren 4 und 5 folgen aufgrund der nicht 4-zähligen Geometrie nicht der in Verbindung mit dem Ausführungsbeispiel gemäß Figuren 1 und 2 angegebenen Formel. Die in Verbindung mit dem Ausführungsbeispiel gemäß Figuren 1 und ausführlich erläuterten Merkmale können aber in analoger Weise auch für die anderen Ausführungsbeispiele der Linse 1 herangezogen werden.

In Figur 6 ist die Linse gemäß Figur 1 modifiziert. Gemäß Figur 6A sind die Koeffizienten $a_1 \neq 0$ und $a_2 = 0$. Hierdurch weisen die Maxima 7a, 7b unterschiedliche Höhen $H_{max,1}$ und $H_{max,2}$ auf. Gemäß Figur 6B sind beide Koeffizienten $a_1$ und $a_2$ gleich groß und von 0 verschieden. Die Maxima 7a, 7b, 7c liegen hierdurch auf unterschiedlichen Höhen. Ebenso ist es möglich, dass dann der Sattelpunkt 6a höher liegt als das Maximum 7c. Durch eine derartige Ausgestaltung der Linse 1, wie in den Figuren 6A, 6B gezeigt, ist eine asymmetrische Abstrahlcharakteristik erzielbar. Solche Linsen 1 können beispielsweise in Eckbereichen einer Anschlussplatte einer Beleuchtungseinrichtung eingesetzt werden.

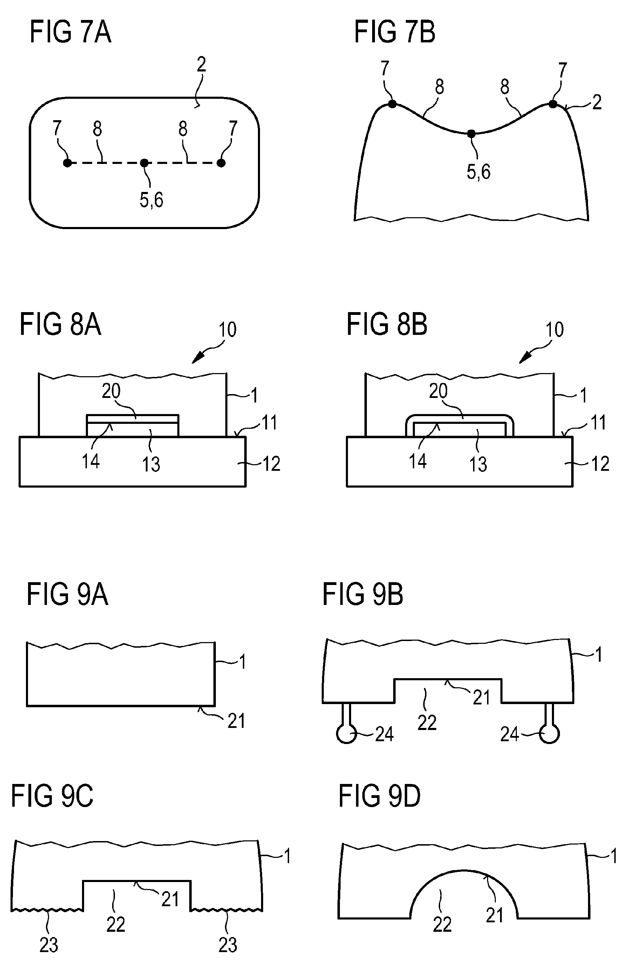

In Figur 7 ist eine Abwandlung einer Linse gezeigt. Die Linse weist eine in Draufsicht gesehen rechteckige Grundform auf, siehe Figur 7A. Die zwei Maxima 7 sind über nur einen Verbindungswall 8 verbunden, wodurch das Minimum 5 mit dem Sattelpunkt 6 zusammenfällt, siehe auch die Schnittdarstellung in Figur 7B.

Beim Ausführungsbeispiel des Halbleiterbauteils 10 gemäß Figur 8A, gezeigt in einer Schnittdarstellung, umfasst der Halbleiterchip 13 an der Strahlungsdurchtrittsseite 14 ein Konversionselement 20, beispielsweise in Form eines aufgeklebten oder aufgedruckten Plättchens. Über das Konversionselement 20 wird mindestens ein Teil der in einer aktiven Halbleiterschicht des Halbleiterchips 13 erzeugten Strahlung in eine Strahlung einer anderen Wellenlänge umgewandelt. Die Linse 1 ist formschlüssig an den Halbleiterchip 13 mit dem Konversionselement 20 angeformt.

Gemäß Figur 8B umgibt das Konversionselement 20 einen Halbleiterkörper des Halbleiterchips 13, mit Ausnahme einer dem Träger 12 zugewandten Seite, allseitig. Auch in diesem Fall ist die Linse 1 formschlüssig mit dem Halbleiterchip 13 und dem Träger 12 ausgebildet.

Bei dieser Ausgestaltung der Linse 1 gemäß Figur 8 weist die Linse 1 also keine Strahlungseintrittsfläche auf. Das heißt, dass keine Zwischenschicht zwischen einem Material der Linse 1 und dem Halbleiterchip 13 vorhanden ist. Hiervon abweichende Möglichkeiten der Gestaltung der Linse 1 sind in den Schnittdarstellungen gemäß Figur 9 gezeigt.

Laut Figur 9A ist eine Strahlungseintrittsfläche 21 der Linse 1 planar geformt. In Figur 9B ist die Linse 1 mit einer Ausnehmung 22 versehen, die quaderartig geformt ist und in der sich die Strahlungseintrittsfläche 21 befindet. Optional kann die Linse 1 Verankerungselemente 24 aufweisen, über die die Linse 1, beispielsweise über ein Stecken, an einen in Figur 9B nicht gezeichneten Träger arretierbar ist. Ein Zwischenraum zwischen der Strahlungseintrittsfläche 21 und einem in der Ausnehmung 22 angebrachten Halbleiterchip 13, in Figur 9 nicht dargestellt, kann mit einem Verbindungsmittel oder mit einem Material zu einer Brechungsindexanpassung ausgefüllt sein. Gemäß Figur 9C sind laterale Bereiche der Linse 1 mit einer Aufrauung 23 versehen. Laut Figur 9D weist die Linse 1 eine Ausnehmung 22 auf und die Lichteintrittsfläche 21 ist kuppelartig geformt.

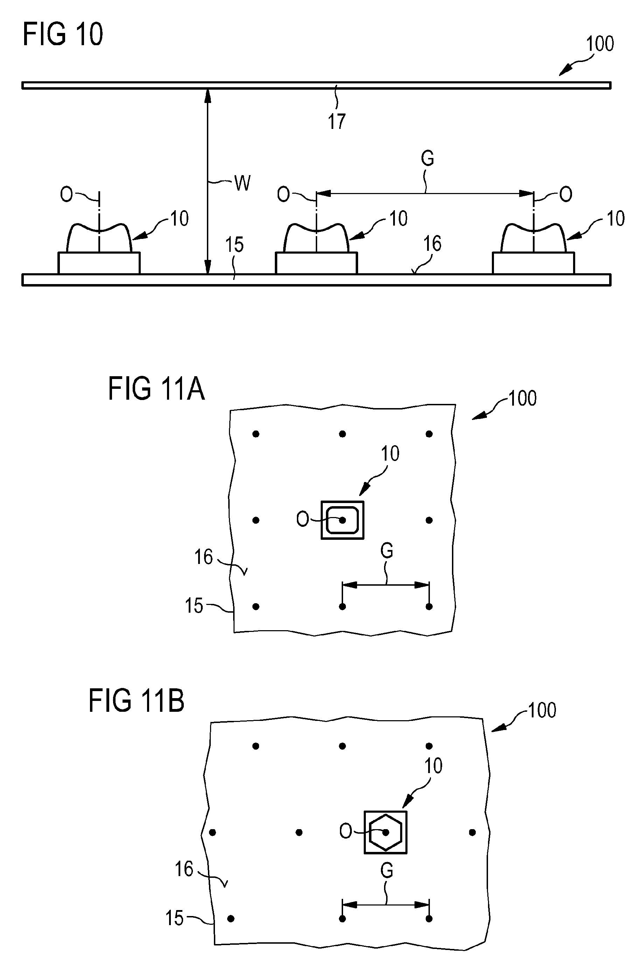

In Figur 10 ist ein Ausführungsbeispiel einer Beleuchtungseinrichtung 100 gezeigt. Auf einer Oberseite 16 einer Anschlussplatte 15 sind an Gitterplätzen eines regelmäßigen Gitters in Abständen G mehrere der Halbleiterbauteile 10 montiert. Der Abstand G, gerechnet zwischen den optischen Achsen O benachbarter Halbleiterbauteile 10, liegt bevorzugt zwischen einschließlich 20 mm und 200 mm und entspricht auch einer Gitterkonstanten G des Gitters. Die Oberseite 16 kann diffus oder spekular reflektierend ausgeführt sein. Ein Reflexionskoeffizient der Oberseite 16 beträgt bevorzugt mindestens 90 % oder mindestens 92,5 %. Spekular reflektierend bedeutet hierbei, dass sich die Oberseite 16 wie eine glatte Spiegeloberfläche verhält. Weiterhin weist die Beleuchtungseinrichtung 100 eine Streuplatte 17 auf. Die Streuplatte 17 ist zum Beispiel in einer Entfernung W zwischen einschließlich 10 mm und 100 mm zu der Oberseite 16 der Anschlussplatte 15 angebracht.

Bei der Streuplatte 17 kann es sich um eine Platte handeln, die eine Reflektivität und ein Transmissionsvermögen von je zirka 50 % aufweist. Ebenso kann es sich um eine Platte handeln, die eine Reflektivität von zirka 75 % und eine Transmission von zirka 18 % aufweist. Bei der Entfernung W von 37 mm und bei Linsen 1 gemäß Figur 1 ist ein Quotient aus einer lokalen, minimalen Energiedichte und einer lokalen, maximalen Energiedichte an einer der Anschlussplatte 15 abgewandten Seite der Streuplatte 17 größer als zirka 94 %, ohne die Streuplatte 17 ist dieser Quotient, in derselben Ebene bestimmt, größer als zirka 89 %. Eine Farbinhomogenität beträgt, bezogen auf eine $c_x$-Koordinate in der CIE-Normfarbtafel bei einem $c_x$-Wert um 0,27, jeweils höchstens 0,01. Bei der Entfernung W von nur 30 mm und mit auf diese geringere Entfernung W gegenüber den Linsen 1 aus Figur 1 modifizierten Linsen, hier nicht dargestellt, liegt dieser Quotient ohne die Streuplatte 17 bei mehr als zirka 70 % und mit Streuplatte 17 bei mehr als zirka 84 %. Die Farbinhomogenität, bezogen auf die $c_x$-Koordinate in der CIE-Normfarbtafel, beträgt ohne Streuplatte 17 höchstens 0,02 und mit Streuplatte 17 höchstens 0,01.

Mit anderen Worten ist durch die dargestellte Beleuchtungseinrichtung 10 eine sehr homogene Beleuchtung einer Fläche zum Beispiel nahe der Streuplatte 17 erzielbar, bei einer nur geringen Dicke der Beleuchtungseinrichtung 100. Dies ist insbesondere durch die Linsen 1 ermöglicht.

In Figur 11 sind Draufsichten auf die Anschlussplatte 15 von weiteren Ausführungsbeispielen der Beleuchtungseinrichtung 100 dargestellt. Gemäß Figur 11A ist das Gitter, in dem die Halbleiterbauteile 10 angeordnet sind, quadratisch, gemäß Figur 11B hexagonal. Eckbereiche der Linsen 1 der Halbleiterbauteile 10 weisen jeweils in solche Richtungen, die Winkelhalbierenden zwischen nächstbenachbarten Gitterpunkten entsprechen. Dadurch ist eine vergleichsweise hohe Lichtintensität entlang dieser Richtungen, gemäß Figur 11A also etwa entlang von Diagonalen, erzielbar. An Ecken und/oder Rändern der Anschlussplatte 15 können die Halbleiterbauteile 10 gedreht angeordnet oder beispielsweise gemäß Figur 6 geformt sein.

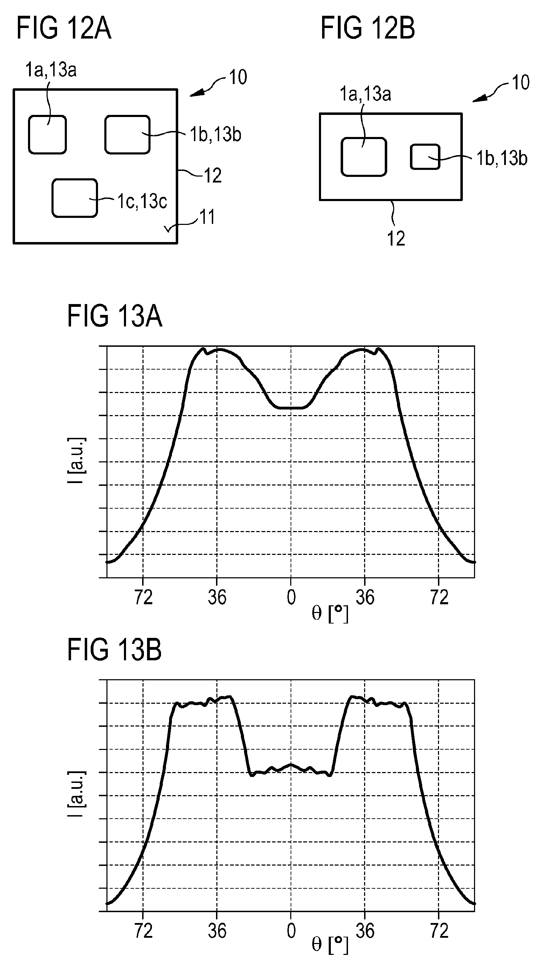

Bei den Halbleiterbauteilen 10 gemäß Figur 11 handelt es sich insbesondere um Halbleiterbauteile, die weißes Licht emittieren, also beispielsweise um Halbleiterbauteile 10 gemäß Figur 8. Ebenso ist es möglich, dass ein Halbleiterbauteil 10 einen im Roten, einen im Grünen und einem im Blauen emittierenden Halbleiterchip 13a, 13b, 13c aufweist. Die Halbleiterchips 13a, 13b, 13c sind bevorzugt je mit einer eigenen Linse 1a, 1b, 1c versehen und auf dem gemeinsamen Träger 12 angeordnet. Die Linsen 1a, 1b, 1c weisen bevorzugt ferner, im Vergleich zum Ausführungsbeispiel gemäß Figur 1, verkleinerte Abmessungen auf, siehe Figur 12A.

Gemäß Figur 12B ist auf dem gemeinsamen Träger 12 ein Halbleiterchip 13a unter der Linse 1a angebracht, der weißes Licht emittiert. Zusätzlich ist ein Halbleiterchip 13b mit einer vergleichsweise kleinen Linse 1b angebracht, der Licht im roten Spektralbereich emittiert. Solche Halbleiterbauteile 10 können, insbesondere beim Einsatz der Beleuchtungseinrichtung 100 zu Zwecken der Allgemeinbeleuchtung, einen hohen Farbwiedergabeindex der emittierten Strahlung gewährleisten. Alternativ zu der Ausführung gemäß Figuren 12A und 12B ist es ebenso möglich, dass je eine Linse und der zugehörige Halbleiterchip auf einem eigenen, separaten Träger montiert sind.

In den Figuren 13A und 13B ist eine Intensität I in einem optischen Fernfeld, aufgetragen in willkürlichen Einheiten, in Abhängigkeit von dem Abstrahlwinkel $\theta$ in ° zur optischen Achse O dargestellt. Gemäß Figur 13A handelt es sich um das Halbleiterbauteil 10 nach den Figuren 1 und 2. In Figur 13B ist die Intensität I im optischen Fernfeld für ein weiteres Ausführungsbeispiel des Halbleiterbauteils gezeigt.

Die hier beschriebene Erfindung ist nicht durch die Beschreibung anhand der Ausführungsbeispiele beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

**Patentansprüche**

1. Linse (1) für ein optoelektronisches Halbleiterbauteil (10) für eine Beleuchtungseinrichtung (100) mit einer Strahlungsaustrittsfläche (2) und mit einer optischen Achse (O), wobei die Strahlungsaustrittsfläche (2)

   - ein Minimum (5), das in einem Zentralbereich (3) liegt, aufweist,
   - mindestens zwei lokale Maxima (7) aufweist,
   - mindestens zwei Verbindungswälle (8) aufweist, die jeweils von einem der Maxima (7) zu einem anderen der Maxima (7) reichen und die, zusammen mit den Maxima (7), das Minimum (5) lateral vollständig umringen, und

   die Linse genau eine Strahlungsaustrittsfläche (2) aufweist und die Strahlungsaustrittsfläche (2) glatt ist, sodass die Strahlungsaustrittsfläche (2) der Linse (1) frei von Ecken und Kanten ist und durch eine zweidimensionale, differenzierbare Funktion beschreibbar ist, **dadurch gekennzeichnet, dass** jeder Verbindungswall (8) einen Sattelpunkt (6) aufweist, der höher als das Minimum (5) und tiefer als die an den Verbindungswall (8) grenzenden Maxima (7)liegt, und ein Betrag einer mittleren Krümmung (K) der Strahlungsaustrittsfläche (2) der Linse (1) in dem Zentralbereich (3) kleiner ist als in den Maxima (7) und als in den Sattelpunkten (6).

2. Linse (1) nach dem vorhergehenden Anspruch,

die mindestens drei lokale Maxima (7) aufweist, wobei eine Anzahl der Maxima (7) gleich einer Anzahl der Sattelpunkte (6) und einer Anzahl der Verbindungswälle (8) ist,
wobei das Minimum (5) von der optischen Achse (O) durchstoßen ist, und
wobei die Linse (1) eine 4-zählige Geometrie aufweist.

**3.** Optoelektronisches Halbleiterbauteil (10) für eine Beleuchtungseinrichtung (100) mit

- einem Träger (12),
- mindestens einem optoelektronischen Halbleiterchip (13), der an dem Träger (12) angebracht ist und der eine dem Träger (12) abgewandte Strahlungsdurchtrittsseite (14) aufweist, durch die eine Ebene (P) definiert ist, und
- einer Linse (1) nach einem der vorhergehenden Ansprüche.

**4.** Optoelektronisches Halbleiterbauteil (10) nach dem vorhergehenden Anspruch,
bei dem eine laterale Abmessung (L) der Linse (1) in der Ebene (P) höchstens ein Zehnfaches einer lateralen Ausdehnung (D) des Halbleiterchips (13) entlang derselben Richtung beträgt,
wobei die Strahlungsaustrittsfläche (2) eine einzige, zusammenhängende und glatte Fläche ist.

**5.** Optoelektronisches Halbleiterbauteil (10) nach einem der Ansprüche 3 oder 4,
bei dem ein Abstand (T) zwischen zwei der Maxima (7) zwischen einschließlich dem 0,4-Fachen und dem 0,9-Fachen der lateralen Abmessung (L) der Linse in der Ebene (P) entlang derselben Richtung beträgt.

**6.** Optoelektronisches Halbleiterbauteil (10) nach einem der Ansprüche 3 bis 5,
bei dem, bezogen auf die Ebene (P), eine Höhe $H_S$ der Sattelpunkte (6) jeweils zwischen einschließlich dem 1,2-Fachen und dem 2,0-Fachen einer Höhe $H_{min}$ des Minimums (5) beträgt.

**7.** Optoelektronisches Halbleiterbauteil (10) nach einem der Ansprüche 3 bis 6,
bei dem, bezogen auf die Ebene (P), eine Höhe $H_{max}$ der Maxima jeweils zwischen einschließlich dem 1,25-Fachen und dem 2,25-Fachen der Höhe $H_{min}$ des Minimums (5) beträgt.

**8.** Optoelektronisches Halbleiterbauteil (10) nach einem der Ansprüche 3 bis 7,
bei dem die Höhe $H_{min}$ des Minimums (5), bezogen auf die Ebene (P), zwischen einschließlich dem 0,6-Fachen und dem 4,0-Fachen einer Kantenlänge (E) des Halbleiterchips (13) beträgt.

**9.** Optoelektronisches Halbleiterbauteil (10) nach einem der Ansprüche 3 bis 8,
bei dem die Linse (1) in dem Zentralbereich (3) konkav und in einem Randbereich (4), mindestens auf einer dem Träger (12) abgewandten Seite der Ebene (P) und außerhalb einer optional vorhandenen Randverrundung (9), konvex gekrümmt ist,
wobei die Sattelpunkte (6) und die Maxima (7) jeweils in dem Randbereich (4) liegen.

**10.** Optoelektronisches Halbleiterbauteil (10) nach einem der Ansprüche 3 bis 9,
bei dem ein Winkel θ2 zwischen der optischen Achse (O) und den Sattelpunkten (6), bezogen auf einen Durchstoßpunkt der optischen Achse (O) durch die Strahlungsdurchtrittsseite (14) des Halbleiterchips (13), zwischen einschließlich 30° und 50° liegt,
und ein Winkel θ1 zwischen der optischen Achse (O) und den Maxima (7) zwischen einschließlich 35° und 60°,
wobei gilt: θ2 < θ1.

**11.** Optoelektronisches Halbleiterbauteil (10) nach einem der Ansprüche 3 bis 10,
bei dem die Linse (1) ein Vergusskörper ist, der an den Träger (12) und an den Halbleiterchip (13) angeformt ist.

**12.** Optoelektronisches Halbleiterbauteil (10) nach einem der Ansprüche 3 bis 11,
bei dem die Höhe h der Strahlungsaustrittsfläche (2) der Linse (1), bezogen auf die Ebene (P), durch ein Polynom der Form

$$h(x,y) = a_0 + a_1 x + a_2 y + a_3(x^2 + y^2) + a_4(x^4 + y^4) + a_5 x^2 y^2 + a_6(x^6 + y^6) + a_7(x^4 y^2 + x^2 y^4) + a_8(x^8 + y^8)$$

approximierbar ist, mit einer Toleranz von höchstens dem 0,02-Fachen der jeweiligen lokalen, tatsächlichen Höhe h(x,y) der Strahlungsaustrittsfläche (2),
wobei mindestens $a_0$, $a_3$, $a_5$ und $a_7$ ungleich Null sind.

13. Optoelektronisches Halbleiterbauteil (10) nach den vorhergehenden Anspruch,
bei dem für die Koeffizienten gilt:

$$a_1 \neq 0 \text{ und } a_2 = 0,$$

oder

$$a_1 = a_2 \neq 0.$$

14. Beleuchtungseinrichtung (100) mit einer Anschlussplatte (15) und mit einer Mehrzahl von optoelektronischen Halbleiterbauteilen (10) gemäß einem der Ansprüche 3 bis 13,
wobei mindestens ein Teil der Halbleiterbauteile (10) an Gitterpunkten eines regelmäßigen Gitters auf einer Anschlussplatte (15) angeordnet ist.

15. Beleuchtungseinrichtung (100) nach dem vorhergehenden Anspruch,
die eine Streuplatte (17) umfasst, die in einer Entfernung (W) zwischen einschließlich 10 mm und 100 mm zu der Anschlussplatte (15) angebracht ist,
wobei eine den Halbleiterbauteilen (10) zugewandte Oberseite (16) der Anschlussplatte (15) spekular oder diffus reflektierend gestaltet ist,
und wobei eine Gitterkonstante (G) des regelmäßigen Gitters zwischen einschließlich 20 mm und 200 mm beträgt.

### Claims

1. Lens (1) for an optoelectronic semiconductor component (10) for a lighting device (100) having a radiation exit surface (2) and having an optical axis (O),
wherein the radiation exit surface (2)

   - has a minimum (5) lying in a central region (3),
   - has at least two local maxima (7),
   - has at least two connecting walls (8) which extend in each case from one of the maxima (7) to another of the maxima (7), and which, together with the maxima (7), laterally completely surround the minimum (5) and

   the lens has exactly one radiation exit surface (2) and the radiation exit surface (2) is smooth, such that the radiation exit surface (2) of the lens (1) is free of corners and edges and is describable by a two-dimensional, differentiable function, **characterized in that**
   each connecting wall (8) has a saddle point (6) which is higher than the minimum (5) and lower than the maxima (7) adjoining the connecting wall (8), and
   an absolute value of an average curvature (K) of the radiation exit surface (2) of the lens (1) is smaller in the central region (3) than in the maxima (7) and than in the saddle points (6).

2. Lens (1) according to the preceding claim,
which has at least three local maxima (7),
wherein a number of the maxima (7) is equal to a number of the saddle points (6) and a number of the connecting walls (8),
wherein the minimum (5) is intersected by the optical axis (O), and
wherein the lens (1) has a four-fold geometry.

3. Optoelectronic semiconductor component (10) for a lighting device (100) comprising

   - a carrier (12),

- at least one optoelectronic semiconductor chip (13) which is fitted to the carrier (12) and which has a radiation passage side (14) facing away from the carrier (12), a plane (P) being defined by said radiation passage side, and

a lens (1) according to either of the preceding claims.

4. Optoelectronic semiconductor component (10) according to the preceding claim,
   wherein a lateral dimension (L) of the lens (1) in the plane (P) is at most ten times a lateral extent (D) of the semiconductor chip (13) along the same direction,
   wherein the radiation exit surface (2) is a single, continuous and smooth surface.

5. Optoelectronic semiconductor component (10) according to either of Claims 3 and 4,
   wherein a distance (T) between two of the maxima (7) is between, inclusive, 0.4 times and 0.9 times the lateral dimension (L) of the lens in the plane (P) along the same direction.

6. Optoelectronic semiconductor component (10) according to any of Claims 3 to 5,
   wherein, relative to the plane (P), a height $H_S$ of the saddle points (6) is in each case between, inclusive, 1.2 times and 2.0 times a height $H_{min}$ of the minimum (5).

7. Optoelectronic semiconductor component (10) according to any of Claims 3 to 6,
   wherein, relative to the plane (P), a height $H_{max}$ of the maxima is in each case between, inclusive, 1.25 times and 2.25 times the height $H_{min}$ of the minimum (5).

8. Optoelectronic semiconductor component (10) according to any of Claims 3 to 7,
   wherein the height $H_{min}$ of the minimum (5), relative to the plane (P) is between, inclusive, 0.6 times and 4.0 times an edge length (E) of the semiconductor chip (13).

9. Optoelectronic semiconductor component (10) according to any of Claims 3 to 8,
   wherein the lens (1) is curved concavely in the central region (3) and convexly in an edge region (4), at least on a side of the plane (P) facing away from the carrier (12) and outside an edge rounding (9) optionally present,
   wherein the saddle points (6) and the maxima (7) in each case lie in the edge region (4).

10. Optoelectronic semiconductor component (10) according to any of Claims 3 to 9,
    wherein an angle $\theta2$ between the optical axis (O) and the saddle points (6), relative to an intersection point of the optical axis (O) through the radiation passage side (14) of the semiconductor chip (13), is between 30° and 50° inclusive,
    and an angle $\theta1$ between the optical axis (O) and the maxima (7) is between 35° and 60° inclusive, wherein it holds true that: $\theta2 < \theta1$.

11. Optoelectronic semiconductor component (10) according to any of Claims 3 to 10,
    wherein the lens (1) is a potting body moulded onto the carrier (12) and onto the semiconductor chip (13).

12. Optoelectronic semiconductor component (10) according to any of Claims 3 to 11,
    wherein the height h of the radiation exit surface (2) of the lens (1), relative to the plane (P), is approximatable by a polynomial of the form

$$h(x,y) = a_0 + a_1 x + a_2 y + a_3 (x^2 + y^2) + a_4 (x^4 + y^4) + a_5 x^2 y^2 + a_6 (x^6 + y^6) + a_7 (x^4 y^2 + x^2 y^4) + a_8 (x^8 + y^8)$$

with a tolerance of at most 0.02 times the respective local, actual height h(x,y) of the radiation exit surface (2), wherein at least $a_0$, $a_3$, $a_5$ and $a_7$ are not equal to zero.

13. Optoelectronic semiconductor component (10) according to the preceding claim,
    wherein it holds true for the coefficients that:

$$a_1 \neq 0 \text{ and } a_2 = 0,$$

or

$$a_1 = a_2 \neq 0.$$

14. Lighting device (100) comprising a connection board (15) and comprising a plurality of optoelectronic semiconductor components (10) according to any of Claims 3 to 13,
wherein at least one portion of the semiconductor components (10) is arranged at lattice points of a regular lattice on a connection board (15).

15. Lighting device (100) according to the preceding claim,
which comprises a diffusing plate (17) fitted at a distance (W) of between 10 mm and 100 mm inclusive from the connection board (15),
wherein a top side (16) of the connection board (15) facing the semiconductor components (10) is designed to be specularly or diffusely reflective, and wherein a lattice constant (G) of the regular lattice is between 20 mm and 200 mm inclusive.

**Revendications**

1. Lentille (1) pour un composant semiconducteur optoélectronique (10) pour un dispositif d'éclairage (100) comprenant une surface de sortie de rayonnement (2) et comprenant un axe optique (O),
la surface de sortie de rayonnement (2)

- possédant un minimum (5) qui se trouve dans une zone centrale (3),
- possédant au moins deux maximums locaux (7),
- possédant au moins deux barrières de liaison (8) qui s'étendent respectivement de l'un des maximums (7) à l'autre des maximums (7) et qui, conjointement avec les maximums (7), entourent complètement le minimum (5) latéralement et

la lentille possédant exactement une surface de sortie de rayonnement (2) et la surface de sortie de rayonnement (2) étant lisse, de sorte que la surface de sortie de rayonnement (2) de la lentille (1) est exempte de coins et d'arêtes et peut être décrite par une fonction différentiable à deux dimensions, **caractérisée en ce que**
chaque barrière de liaison (8) possède un point hyperbolique (6) qui est plus haut que le minimum (5) et plus bas que les maximums (7) adjacents à la barrière de liaison (8) et
une valeur d'une courbure moyenne (K) de la surface de sortie de rayonnement (2) de la lentille (1) est plus faible dans la zone centrale (3) que dans les maximums (7) et que dans les points hyperboliques (6).

2. Lentille (1) selon l'une des revendications précédentes, laquelle possède au moins trois maximums (7) locaux, un nombre de maximums (7) étant égal à un nombre de points hyperboliques (6) et à un nombre de barrières de liaison (8),
le minimum (5) étant traversé par l'axe optique (O), et la lentille (1) possédant une géométrie quadrivalente.

3. Composant semiconducteur optoélectronique (10) pour un dispositif d'éclairage (100) comprenant

- un support (12),
- au moins une puce en semiconducteur optoélectronique (13) qui est montée sur le support (12) qui possède un côté de traversée de rayonnement (14) à l'opposé du support (12), par laquelle est défini un plan (P), et
- une lentille (1) selon l'une des revendications précédentes.

4. Composant semiconducteur optoélectronique (10) selon la revendication précédente
dans lequel une dimension latérale (L) de la lentille (1) dans le plan (P) est au maximum égale à un décuple d'une projection latérale (D) de la puce en semiconducteur (13) le long de la même direction,
la surface de sortie de rayonnement (2) étant une surface unique, cohérente et lisse.

5. Composant semiconducteur optoélectronique (10) selon l'une des revendications 3 ou 4,
dans lequel un écart (T) entre deux des maximums (7) est égal à 0,4 fois à 0,9 fois inclus la dimension latérale (L) de la lentille dans le plan (P) le long de la même direction.

**6.** Composant semiconducteur optoélectronique (10) selon l'une des revendications 3 à 5,
dans lequel, en référence au plan (P), une hauteur $H_S$ du point hyperbolique (6) est à chaque fois égale à 1,2 fois à 2,0 fois inclus une hauteur $H_{min}$ du minimum (5).

**7.** Composant semiconducteur optoélectronique (10) selon l'une des revendications 3 à 6,
dans lequel, en référence au plan (P), une hauteur $H_{max}$ des maximums est à chaque fois égale à 1,25 fois à 2,25 fois inclus la hauteur $H_{min}$ du minimum (5).

**8.** Composant semiconducteur optoélectronique (10) selon l'une des revendications 3 à 7,
dans lequel la hauteur $H_{min}$ du minimum (5), en référence au plan (P), est égale à 0,6 fois à 4,0 fois inclus une longueur d'arête (E) de la puce en semiconducteur (13).

**9.** Composant semiconducteur optoélectronique (10) selon l'une des revendications 3 à 8,
dans lequel la lentille (1) est concave dans la zone centrale (3) et à courbure convexe dans une zone de bordure (4), au moins sur un côté du plan (P) à l'opposé du support (12) et en-dehors d'un arrondi du bord (9) présent en option, les points hyperboliques (6) et les maximums (7) se trouvant respectivement dans la zone de bordure (4).

**10.** Composant semiconducteur optoélectronique (10) selon l'une des revendications 3 à 9,
dans lequel un angle $\theta 2$ entre l'axe optique (O) et les points hyperboliques (6), en référence au point de traversée de l'axe optique (O) à travers le côté de traversée de rayonnement (14) de la puce en semiconducteur (13) est compris entre 30° et 50° inclus,
et un angle $\theta 1$ entre l'axe optique (O) et les maximums (7) entre 35° et 60° inclus, avec $\theta 2 < \theta 1$.

**11.** Composant semiconducteur optoélectronique (10) selon l'une des revendications 3 à 10,
dans lequel la lentille (1) est un corps coulé qui est façonné sur le support (12) et sur la puce en semiconducteur (13).

**12.** Composant semiconducteur optoélectronique (10) selon l'une des revendications 3 à 11,
dans lequel la hauteur h de la surface de sortie de rayonnement (2) de la lentille (1), en référence au plan (P), peut être définie approximativement par un polynôme de la forme

$$h(x,y) = a_0 + a_1x + a_2y + a_3(x^2 + y^2) + a_4(x^4 + y^4) + a_5x^2y^2 + a_6(x^6 \ y^6) + a_7(x^4y^2 + x^2y^4) + a_8(x^8 + y^8),$$

avec une tolérance maximale égale à 0,02 fois la hauteur locale h(x,y) effective respective de la surface de sortie de rayonnement (2),
au moins $a_0$, $a_3$, $a_5$ et $a_7$ étant différents de zéro.

**13.** Composant semiconducteur optoélectronique (10) selon la revendication précédente,
dans lequel les relations suivantes s'appliquent pour les coefficients :

$$a_1 \neq 0 \text{ et } a_2 = 0,$$

ou

$$a_1 = a_2 \neq 0.$$

**14.** Dispositif d'éclairage (100) comprenant une plaque de raccordement (15) et comprenant une pluralité de composants semiconducteurs optoélectroniques (10) selon l'une des revendications 3 à 13,
au moins une partie des composants semiconducteurs (10) étant disposés aux noeuds d'un réseau régulier sur une plaque de raccordement (15).

**15.** Dispositif d'éclairage (100) selon la revendication précédente,

lequel comprend une plaque de dispersion (17) qui est montée à une distance (W) entre 10 mm et 100 mm inclus de la plaque de raccordement (15),
un côté supérieur (16) de la plaque de raccordement (15) faisant face aux composants semiconducteurs (10) étant réalisé à réflexion spéculaire ou diffuse,
et une constante de réseau (G) du réseau régulier étant comprise entre 20 mm et 200 mm inclus.

FIG 1A

FIG 1B

# FIG 2A

# FIG 2B

FIG 2C

FIG 2D

FIG 2E

FIG 3A

FIG 3B

FIG 4A

FIG 4B

FIG 5A

FIG 5B

FIG 6A

FIG 6B

FIG 7A

FIG 7B

FIG 8A

FIG 8B

FIG 9A

FIG 9B

FIG 9C

FIG 9D

## FIG 10

## FIG 11A

## FIG 11B

## FIG 12A

## FIG 12B

## FIG 13A

## FIG 13B

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102006050880 A1
- CN 201330994 Y
- WO 2009015605 A1
- US 20090032827 A1
- US 6273596 B1